Europäisches Patentamt

European Patent Office

Office européen des brevets

(19)

(11) **EP 1 006 697 A2**

(12) **EUROPEAN PATENT APPLICATION**

(43) Date of publication:
07.06.2000 Bulletin 2000/23

(51) Int Cl.[7]: **H04L 25/03**

(21) Application number: **99309305.3**

(22) Date of filing: **23.11.1999**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (72) Inventors:<br>• **Azadet, Kameran**<br>  **Middletown, New Jersey 07748 (US)**<br>• **Yu, Meng-Lin My**<br>  **Morganville, New Jersey 07751 (US)** |
| (30) Priority: **02.12.1998  US 203969** | (74) Representative:<br>**Watts, Christopher Malcolm Kelway, Dr. et al**<br>**Lucent Technologies (UK) Ltd,**<br>**5 Mornington Road**<br>**Woodford Green Essex, IG8 0TU (GB)** |
| (71) Applicant: **LUCENT TECHNOLOGIES INC.**<br>**Murray Hill, New Jersey 07974-0636 (US)** | |

(54) **Parellel signal processing for equalisation on fibre channels**

(57)  A method and apparatus are disclosed for reducing dispersion problems in data signals received over a channel, such as a fiber channel. A receiver processes the received data on parallel branches at a rate that is slower than the original clock rate. Channel equalization techniques can thus be applied to fiber channels despite the very high clock rates of the received signal. The clock rate of the received signal is reduced by an arbitrary factor N for sampling and digitizing the analog signal at the output of the fiber channel. The parallel analog samples are digitized before digital signal processing (DSP) techniques are applied by an adaptive digital signal processor to perform data detection. The adaptive digital signal processor may be embodied, for example, as an adaptive channel equalizer that utilizes an adaptive feed forward equalizer (FFE), or as a maximum likelihood sequence estimator (MLSE), such as a Viterbi detector.

FIG. 3

EP 1 006 697 A2

## Description

### Field of the Invention

The present invention relates generally to channel equalization techniques, and more particularly, to channel equalization techniques for reducing dispersion problems in fiber channels.

### Background of the Invention

The transmission rates for local area networks (LANs) have progressively increased from 10 Megabits-per-second (Mbps) using twisted pair conductors to 1 Gigabit-per-second (Gbps) using multi-mode fiber channels. In a multi-mode fiber, the light rays follow different paths, often with their own respective lengths and therefore exhibit delay spread. A result of delay spread in a multi-mode fiber channel is that it considerably reduces the distance over which digital data can be accurately transmitted. Typical fibers used for gigabit transmission have a cutoff frequency specification of 200 Megahertz kilometer (MHz-km). Thus, there is a trade-off between channel lengths and bandwidth. As an example, for a multi-mode 200 Megahertz kilometer (MHz-km) fiber having a bandwidth of 1 Gigahertz (GHz), the cable length should be limited to approximately 200 meters. The Gigabit Ethernet standard, for example, operates at a bit rate of 1.25 Gigabits-per-second (GBps), has a corresponding bandwidth of 612.5 MHz and thus has a maximum channel length of 326.5 meters. In order to guarantee reliable data transmission over all grades and brands of previously installed multi-mode fibers, however, the Gigabit Ethernet standard limits the maximum channel length to 275 meters,. It is desirable, however, to transmit digital signals on a fiber channel over distances of one kilometer or more.

Although fiber channel lengths for high speed digital signals could be increased by implementing channel equalization techniques in the receiver, such as those channel equalization techniques applied to more non-fiber based channels, e.g., twisted pair conductors, typical fiber receivers have not implemented any kind of sophisticated channel equalization. This is because of the practical difficulty of implementing a channel equalizer that operates at such high clock rates, e.g., on the order of one Gigahertz.

### Summary of the Invention

Generally, a method and apparatus are disclosed for reducing delay spread problems in data signals received over a channel, such as a fiber channel, by processing the received data on parallel branches at a rate that is slower than the original clock rate. The present invention makes channel equalization possible, despite the very high clock rates of the received signal. The original clock rate of the received signal is reduced by an arbitrary factor, N. The received signal is sampled and digitized using N parallel paths that are each triggered with a clock that is 1/N-times as fast as the original clock rate. The converted samples are processed using digital signal processing (DSP) techniques.

In one implementation, the incoming signal is sampled and digitized in parallel at a clock rate that is 1/N-times as fast as the incoming clock rate. The analog samples are digitized in parallel before digital signal processing (DSP) techniques are applied by an adaptive digital signal processor to perform data detection. The adaptive digital signal processor may be embodied, for example, as an adaptive channel equalizer that utilizes an adaptive feed forward equalizer (FFE), as a combined adaptive feed forward equalizer (FFE) with a decision feedback equalizer (DFE), or as a maximum likelihood sequence estimator (MLSE), such as a Viterbi detector, combined with channel estimation.

### Brief Description of the Drawings

FIG. 1 is a schematic block diagram of a receiver in accordance with the present invention that reduces dispersion problems in data signals received over a fiber channel;

FIG. 2 illustrates the incoming clock, clk, associated with the received data, and the various 1/N-times slower clocks, $\Phi_1$ through $\Phi_N$, of FIG. 1;

FIG. 3 illustrates one suitable implementation of circuitry for the receiver of FIG. 1 in accordance with the present invention;

FIG. 4 illustrates an adaptive channel equalizer implementation of the receiver of FIG. 1;

FIG. 5 illustrates an implementation of the adaptive channel equalizer of FIG. 4;

FIG. 6 illustrates a maximum likelihood sequence estimation implementation of the receiver of FIG. 1;

FIG. 7 illustrates a schematic block diagram of a parallel channel equalizer, and

FIG. 8 illustrates a parallel finite impulse response (FIR) filter implementation of Equation 6.

## Detailed Description

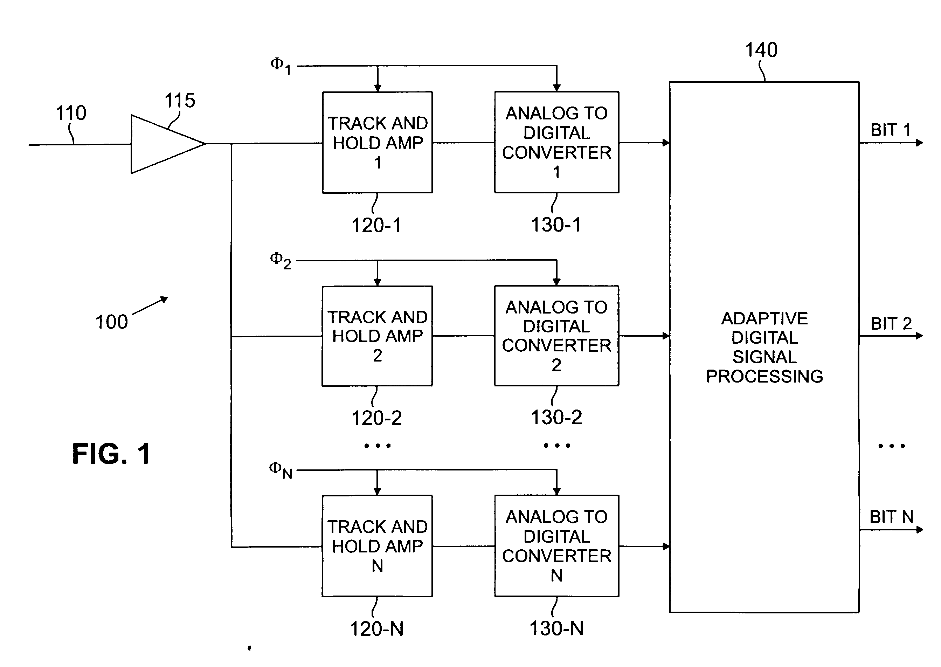

FIG. 1 illustrates a receiver 100 in accordance with the present invention that reduces dispersion problems in data signals received over a fiber channel 110. According to a feature of the present invention, the receiver 100 processes different portions of the received data on parallel branches at a rate that is slower than the original clock rate. Thus, the present invention makes channel equalization possible for fiber channels despite the very high clock rates of the received signal and appears to perform channel equalization at the original clock rate. As discussed further below, N trigger clocks, $\Phi_1$ through $\Phi_N$, are generated from the clock rate of the received signal. Thus, the clock rate of each of the trigger clocks, $\Phi_1$ through $\Phi_N$, is reduced by an arbitrary factor N for sampling and digitizing the analog signal at the output of the fiber channel 110, and then processing the converted samples using digital signal processing (DSP) techniques. For example, if the bit rate is 1.25 Gigabits-per-second (Gbps), and the receiver 100 includes N=10 parallel processing paths, the signals can be sampled, digitized and processed using a 1/N-times as fast clock rate of 125 Megahertz (MHz). Thus, each bit can be processed for 8 nanoseconds, which is achievable with currently available technology.

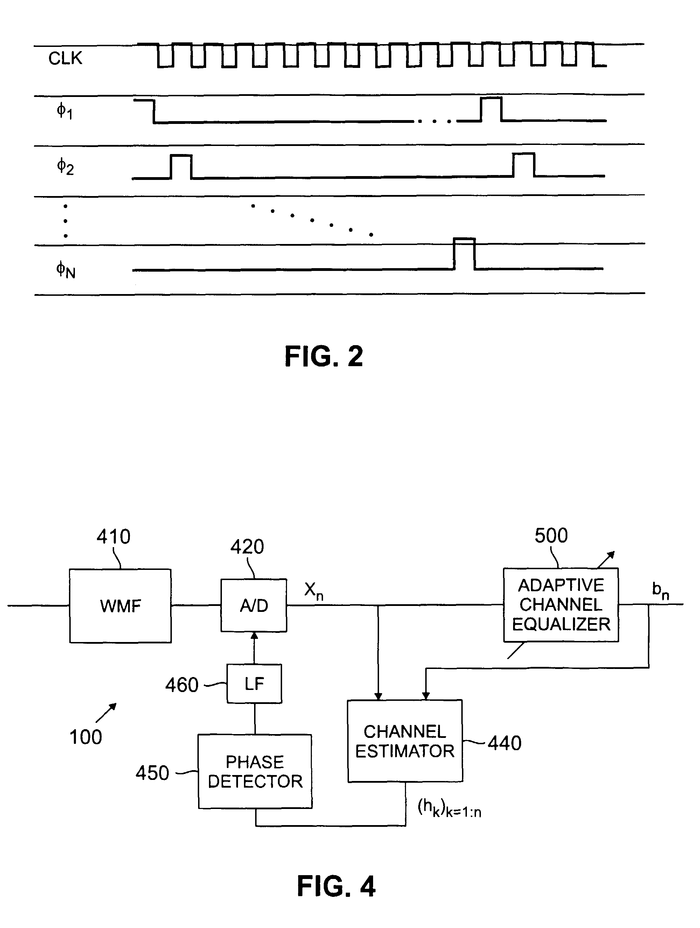

As shown in FIG. 1, the energy of the received signal is increased by a preamplifier 115 before being sampled by a series of N track and hold circuits 120-1 through 120-N that are each triggered by a respective trigger clock, $\Phi_1$ through $\Phi_N$, that is 1/N-times as fast as the incoming clock rate. The incoming clock, clk, associated with the received data, and the various 1/N-times slower clocks, $\Phi_1$ through $\Phi_N$, are shown in FIG. 2. In this manner, the received data can be processed in parallel at a rate that is 1/N-times as fast as the incoming clock rate. The parallel analog samples are then converted to a digital signal by N analog-to-digital converters 130-1 through 130-N before digital signal processing (DSP) techniques are applied by an adaptive digital signal processor 140 in order to perform data detection, discussed below.

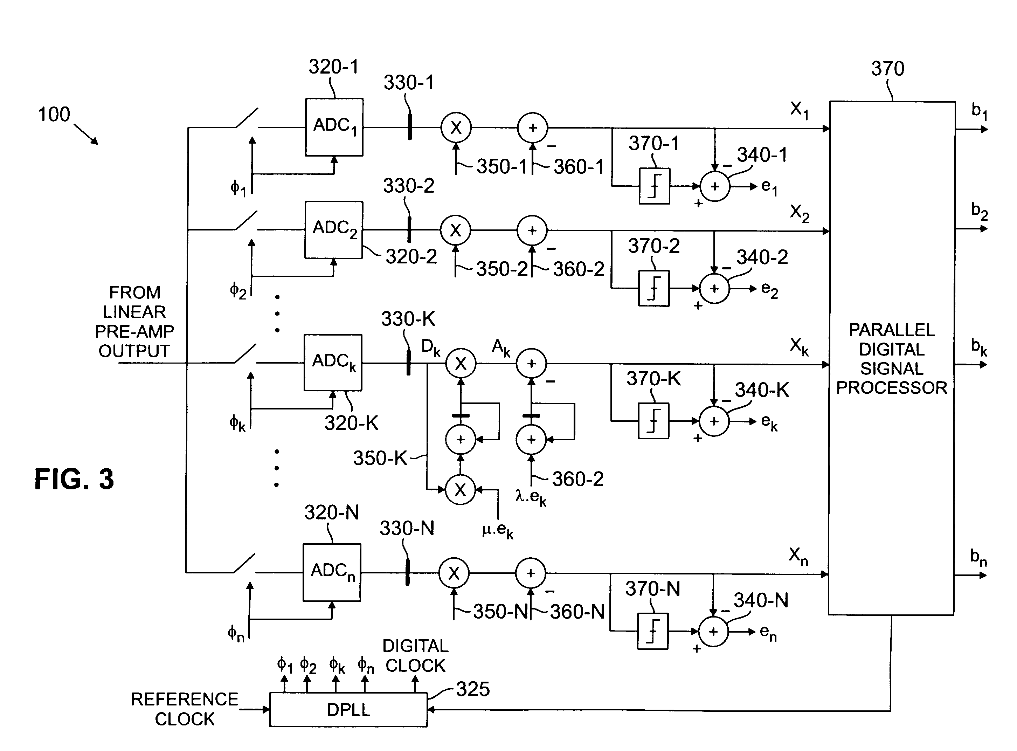

FIG. 3 illustrates one suitable implementation of the receiver 100 in accordance with the present invention. As shown in FIG. 3, the analog data from the output of the preamplifier 115 (FIG. 1) is applied to N analog-to-digital converters 320-1 through 320-N that are each triggered by a respective trigger clock, $\Phi_1$ through $\Phi_N$, that is 1/N-times as fast as the incoming clock rate. A digital phase locked loop (DPLL) 325 performs clock recovery of the incoming clock signal, clk, associated with the received data, and generates the various 1/N-times faster clocks, $\Phi_1$ through $\Phi_N$. In this manner, the received data is processed in parallel at a rate that is 1/N-times as fast as the incoming clock rate. The digital outputs of the analog-to-digital converters 320-1 through 320-N are stored in N registers 330-1 through 330-N that are all triggered by the same 1/N-times as fast digital clock to resynchronize the parallel branches.

Since each of the analog-to-digital converters 320-1 through 320-N and corresponding track and hold amplifiers 120-1 through 120-N have a unique offset and gain error, the receiver 100 optionally includes error estimation circuits 340-1 through 340-N, gain control circuits 350-1 through 350-N and offset cancellation circuits 360-1 through 360-N for each of the N parallel branches. Although the error estimation circuit 340-k, gain control circuits 350-k and offset cancellation circuits 360-k are only shown in detail in FIG. 3 for the k-th branch of the receiver 100, corresponding error estimation circuits 340-1 through 340-N, gain control circuits 350-1 through 350-N and offset cancellation circuits 360-1 through 360-N would be included in each of the N parallel branches. A reference signal is applied, and the error estimation circuits 340-1 through 340-N measure the error and generate an error signal, $e_N$. The error signal is generated by comparing the detected value, X, to a two level quantized value produced by a quantizer 370-1 through 370-N. In one embodiment, the quantizer 370-1 through 370-N receives the value X, and generates an applied reference signal indicating the sign of X (having a value equal to positive or negative 1).

Generally, if the applied reference signal is a binary "1," and a value of .9 is measured, the error signal, $e_N$, is 1. The error signal, $e_N$, is used to update the gain control circuits 350-1 through 350-N and offset cancellation circuits 360-1 through 360-N. As shown in FIG. 3, for the *k*-th parallel branch, the raw output of the analog-to-digital converter 320-k is $D_k$, and the gain correction circuit 350-k produces a signal $A_k$, that is gain error free. The corrected and calibrated digital data is referred to as $X_k$. Each of the individual gain and offset errors are corrected since the incoming symbol on each path is random and cyclostationary (a random variable that periodically has the same statistical properties).

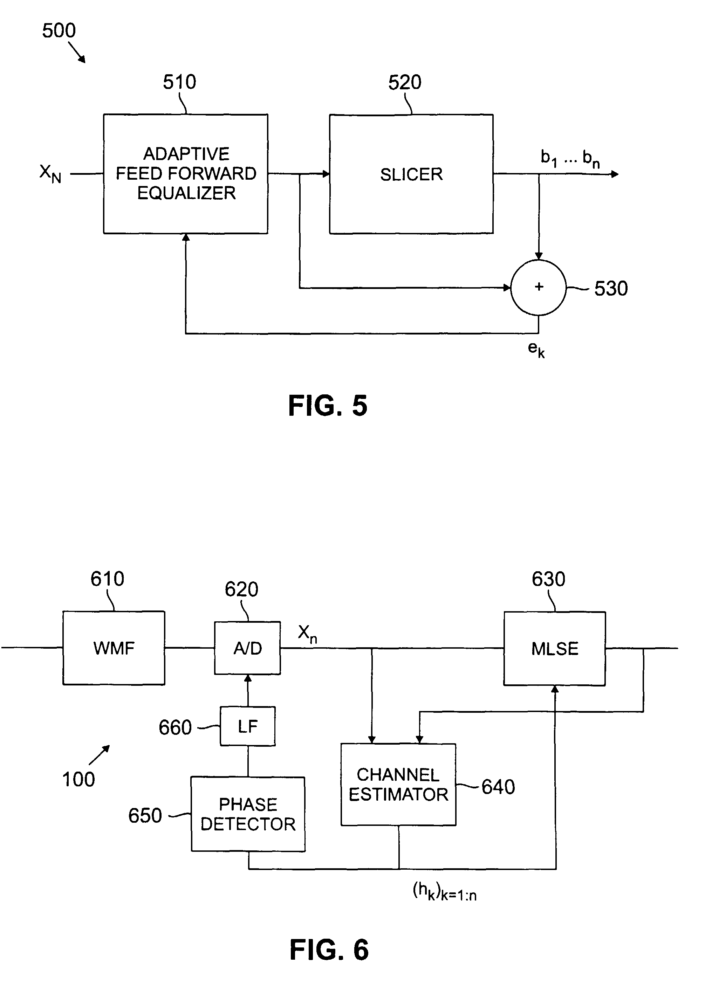

Thereafter, the digital data, $X_k$, is operated on by an adaptive digital signal processor 370 that performs channel equalization and data detection to produce the output symbols or bits, $b_1$ though $b_n$. As discussed below in conjunction with FIGS. 4 through 6, the adaptive digital signal processor 370 may be embodied, for example, as an adaptive channel equalizer 500 or a maximum likelihood sequence estimator (MLSE) 650, such as a Viterbi detector.

FIG. 4 illustrates one suitable implementation of a receiver 100 in accordance with the present invention. As shown in FIG. 4, the receiver 100 includes an analog whitening matched filter (WMF) 410 that preprocesses the analog signal prior to digitization by an analog-to-digital (A/D) converter 420. The digitized data is then processed by an adaptive channel equalizer 500, discussed further below in conjunction with FIG. 5, that produces the output symbols or bits, $b_1$ though $b_n$.

The feedback loop includes a channel estimator 440 that determines appropriate tap weight values to perform clock recovery. In the illustrative implementation, the channel estimator 440 uses the decided symbols from the adaptive channel equalizer 500 to perform blind or decision-directed tap adaptation. The channel estimator 440 is discussed further below in a section entitled PARALLEL IMPLEMENTATION OF A CHANNEL EQUALIZER. The tap weights, $h_k$, determined by the channel estimator 440 are applied in the clock recovery loop by a phase detector 450 and a low pass filter 460 to select a clock phase and generate the 1/N clocks. Each time the tap weights, $h_k$, are adjusted, a new clock phase is selected in the clock recovery loop.

FIG. 5 illustrates the adaptive channel equalizer 500 of FIG. 4. As shown in FIG. 5, the adaptive channel equalizer 500 includes an adaptive feed forward equalizer (FFE) 510 in parallel form, and a slicer 520 that quantizes the digital data. An implementation of the adaptive feed forward equalizer (FFE) 510 is discussed further below in a section entitled PARALLEL IMPLEMENTATION OF A CHANNEL EQUALIZER. An error signal, $e_k$, is generated in the feedback loop by a summer 530 that adapt the taps of the adaptive feed forward equalizer (FFE) 510. It is noted that the performance of the adaptive channel equalizer 500 can be enhanced using a decision feedback equalizer (DFE) (not shown). For a detailed discussion of parallel decision feedback equalizers (DFEs), see Kalavai J. Raghunath and Keshab Parhi, "Parallel Adaptive Decision Feedback Equalizers," IEEE Trans. on Signal Processing, Vol. 41, No. 5 (May 1993), incorporated by reference herein.

FIG. 6 illustrates an alternate implementation of a receiver 100 in accordance with the present invention. As shown in FIG. 6, the receiver 100 includes an analog whitening matched filter (WMF) 610 that preprocesses the analog signal prior to digitization by an analog-to-digital (A/D) converter 620. The digitized data is then processed by a maximum likelihood sequence estimator (MLSE) 650, such as a Viterbi detector, that performs data detection without equalization to produce the output symbols or bits, $b_1$ though $b_n$. Maximum likelihood sequence estimators (MLSE) 650 consider a number of possible sequences and determines which sequence was actually received, in a known manner. For a more detailed discussion of a Viterbi implementation of a maximum likelihood sequence estimator (MLSE), see Gerhard Fettweis and Heinrich Meyr, "High-Speed Parallel Viterbi Decoding Algorithm and VLSI-Architecture," IEEE Communication Magazine (May 1991), incorporated by reference herein.

The feedback loop includes a channel estimator 640 that determines appropriate tap weight values to perform maximum likelihood sequence estimation. In the illustrative implementation, the channel estimator 640 uses the decided symbols from the maximum likelihood sequence estimator (MLSE) 630 to perform blind or decision-directed tap adaptation. The channel estimator 640 is discussed further below in a section entitled PARALLEL IMPLEMENTATION OF A CHANNEL EQUALIZER. The tap weights, $h_k$, determined by the channel estimator 640 are applied in the clock recovery loop by a phase detector 650 and a low pass filter 660 to select a clock phase and generate the 1/N times as fast clocks. Each time the tap weights, $h_k$, are adjusted, a new clock phase is selected in the clock recovery loop, in a known manner.

## Parallel Implementation Of A Channel Equalizer

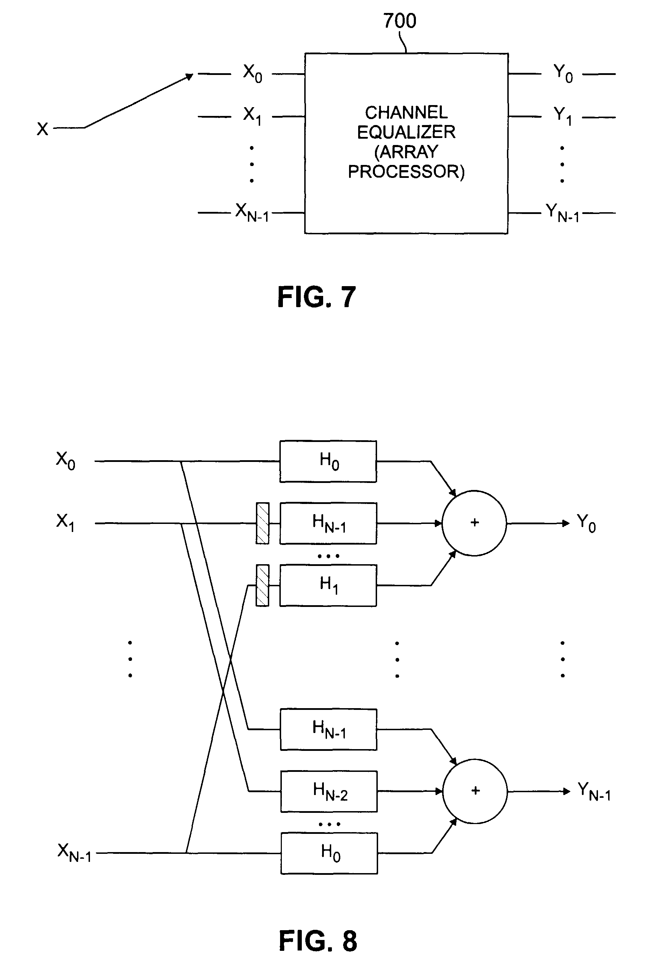

As previously indicated, the channel estimators 440 and 640, as well as the adaptive feed forward equalizer (FFE) 510, require parallel implementations of a channel equalizer 700. FIG. 7 illustrates a schematic block diagram of a parallel channel equalizer. Let X represent the input of the channel equalizer 700 and Y the output, and ($X_0$, $X_1$, .... $X_N$) and ($Y_0$, $Y_1$, ... $Y_N$) the parallel representation of X and Y, respectively, where each of the $X_k$ or $Y_k$ values are clocked 1/N-times as fast as X and Y.

Representing all signals and filter transfer functions with their z transforms:

$$X(z) = X_0(z) + z^{-1}X_1(z) + ... + z^{-N+1}X_{N-1}(z) \qquad \text{Eq. (1)}$$

$$H(z) = H_0(z) + z^{-1}H_1(z) + ... + z^{-N+1}H_{N-1}(z) \qquad \text{Eq. (2)}$$

where $H_j$ and $X_j$ are given by:

$$H_j(z) = \begin{cases} \sum_{k=0}^{m-1-j} h_{kN+j} z^k & \text{if } m-1 \geq j \quad Eq.(3) \\ \\ 0 & \text{if } m-1 \prec j \end{cases}$$

and m is the number of taps for the equalizer. Xj(Z) is the subsample at phase j of the input signal X, as shown in FIG. 7. The output Y(z) is given by:

$$Y(z) = H(z) \, X(z) \qquad\qquad Eq.(4)$$

For a parallel implementation of the filter H, there is a matrix [A], such that:

$$\begin{pmatrix} Y_0 \\ Y_1 \\ \vdots \\ Y_{N-1} \end{pmatrix} = [A] \begin{pmatrix} X_0 \\ X_1 \\ \vdots \\ X_{N-1} \end{pmatrix} \qquad Eq.(5)$$

It can be shown that:

$$\begin{pmatrix} Y_0 \\ Y_1 \\ Y_2 \\ \vdots \\ Y_{N-1} \end{pmatrix} = \begin{pmatrix} H_0 & z^{-1}H_{N-1} & z^{-1}H_{N-2} & \cdots & z^{-1}H_1 \\ H_1 & H_0 & z^{-1}H_{N-1} & \cdots & z^{-1}H_2 \\ H_2 & H_1 & H_0 & \cdots & z^{-1}H_3 \\ \vdots & \vdots & \vdots & \vdots & \ddots & \vdots \\ H_{N-1} & H_{N-2} & H_{N-3} & \cdots & H_0 \end{pmatrix} \begin{pmatrix} X_0 \\ X_1 \\ X_2 \\ \vdots \\ X_{N-1} \end{pmatrix} \qquad Eq.(6)$$

FIG. 8 illustrates a parallel finite impulse response (FIR) filter 800 that implements Equation 6.

**Claims**

1.  A method for receiving a signal from a dispersible channel, said signal having an incoming clock rate, said method comprising the steps of:

    equalizing said channel using a plurality of parallel paths, each of said paths having a clock rate slower than said incoming clock rate; and
    detecting said signal using a digital signal processor (DSP) that processes said signal using said parallel paths.

2.  The method according to claim 1, further comprising the step of sampling said signal on each of said plurality of parallel paths.

3. The method according to claim 1, further comprising the step of digitizing said signal on each of said plurality of parallel paths.

4. The method according to claim 2, wherein said sampling is performed using interleaved analog-to-digital converters.

5. The method according to any of the preceding claims, wherein said equalizing step is performed using N parallel paths, each triggered by a clock that is 1/N-times as fast as said incoming clock rate.

6. The method according to any of the preceding claims, wherein said equalizing and detecting steps are performed using an adaptive channel equalizer.

7. The method according to claim 6, wherein said adapative channel equalizer includes an adaptive feed forward equalizer (FFE).

8. The method according to claim 6, wherein the performance of said adaptive channel equalizer is improved using a decision feedback equalizer (DFE).

9. The method according to any of claims 1 to 5, wherein said detecting step is performed using a maximum likelihood sequence estimator.

10. The method according to claim 9, wherein said maximum likelihood sequence estimator is implemented as a Viterbi detector.

11. A receiver adapted to receive a signal from a channel, said signal having an incoming clock rate, said receiver comprising means for carrying out each step of a method as claimed in any of the preceding claims.

12. A method for calibrating an interleaved analog-to-digital converter to produce a calibrated output of said interleaved analog-to-digital converter, said method comprising the steps of:

   generating an error signal for each path of said interleaved analog-to-digital converter by comparing said calibrated output with a quantized version of said calibrated output; and
   adjusting a gain control circuit as a function of said error signal.

13. A method for calibrating an interleaved analog-to-digital converter to produce a calibrated output of said interleaved analog-to-digital converter, said method comprising the steps of:

   generating an error signal for each path of said interleaved analog-to-digital converter by comparing said calibrated output with a quantized version of said calibrated output; and
   adjusting an offset correction circuit as a function of said error signal.

14. The method according to claim 12 or claim 13, wherein said quantizer provides a two level signal indicating whether said calibrated output is higher or lower than an expected value.

**FIG. 1**

- 110
- 115
- Φ₁ → TRACK AND HOLD AMP 1 (120-1) → ANALOG TO DIGITAL CONVERTER 1 (130-1) → BIT 1
- Φ₂ → TRACK AND HOLD AMP 2 (120-2) → ANALOG TO DIGITAL CONVERTER 2 (130-2) → BIT 2
- Φ_N → TRACK AND HOLD AMP N (120-N) → ANALOG TO DIGITAL CONVERTER N (130-N) → BIT N
- 140 ADAPTIVE DIGITAL SIGNAL PROCESSING
- 100

EP 1 006 697 A2

**FIG. 2**

**FIG. 4**

FIG. 3

500

510

520

$X_N$ — ADAPTIVE FEED FORWARD EQUALIZER — SLICER — $b_1 \dots b_n$

+ — 530

$e_k$

**FIG. 5**

610

620

630

WMF — A/D — $X_n$ — MLSE

660 — LF

650 — PHASE DETECTOR

CHANNEL ESTIMATOR — 640

100

$(h_k)_{k=1:n}$

**FIG. 6**

700

CHANNEL
EQUALIZER
(ARRAY
PROCESSOR)

$X_0$ → $Y_0$
$X_1$ → $Y_1$
$X_{N-1}$ → $Y_{N-1}$

X

**FIG. 7**

$X_0$

$X_1$

$X_{N-1}$

$H_0$

$H_{N-1}$

···

$H_1$

$H_{N-1}$

$H_{N-2}$

···

$H_0$

$+$ → $Y_0$

$+$ → $Y_{N-1}$

**FIG. 8**

11